Europäisches Patentamt

European Patent Office

Office européen des brevets

(19)

(11) Veröffentlichungsnummer: **0 314 918**
**B1**

(12) **EUROPÄISCHE PATENTSCHRIFT**

(45) Veröffentlichungstag der Patentschrift: **02.01.91**

(21) Anmeldenummer: **88115937.0**

(22) Anmeldetag: **28.09.88**

(51) Int. Cl.⁵: **H 01 J 37/248**

(54) **Schaltungsanordnung für die Steuerung eines Elektronenstrahlerzeugers.**

(30) Priorität: **06.11.87 DE 3737691**

(43) Veröffentlichungstag der Anmeldung:
**10.05.89 Patentblatt 89/19**

(45) Bekanntmachung des Hinweises auf die
Patenterteilung:
**02.01.91 Patentblatt 91/01**

(84) Benannte Vertragsstaaten:
**CH DE FR GB IT LI**

(56) Entgegenhaltungen:
**DE-A-2 514 805**
**DE-A-2 615 691**
**DE-C-2 928 301**

(73) Patentinhaber: **LEYBOLD
AKTIENGESELLSCHAFT
Wilhelm-Rohn-Strasse 25
D-6450 Hanau am Main 1 (DE)**

(72) Erfinder: **Stürmer, Johann
Pestalozzistrasse 8
D-6463 Freigericht 1 (DE)**

(74) Vertreter: **Schickedanz, Willi, Dipl.-Ing.
Langener Strasse 68
D-6050 Offenbach/Main (DE)**

Courier Press, Leamington Spa, England.

## Beschreibung

Die Erfindung betrifft eine Schaltungsanordnung für die Steuerung eines Elektronenstrahlerzeugers mit einer Katode, einer Anode und einer Steuerelektrode, wobei eine amplitudenmodulierte Spannung gleichgerichtet und über ein Filter zwischen Katode und Steuerelektrode gelegt wird.

Bei Hochspannungs-Elektronenstrahlerzeugern, die im allgemeinen mit einer Anodenspannung von mehr als 20 Kilovolt betrieben werden und die daher bei gegebener Leistung einen relativ geringen Strahlstrom aufweisen, ist in der Nähe der Katode eine zylinderförmige Steuerelektrode angeordnet, die häufig auch als Wehnelt-Zylinder bezeichnet wird. Mit dieser Steuerelektrode ist es möglich, den Elektronenstrahlstrom zwischen 0 und 100% zu verändern. Zu diesem Zweck wird an die Steuerelektrode eine gegenüber der Katode in ihrer Amplitude variable, negative Spannung angelegt, die das Austreten von Elektronen in Richtung zur Anode je nach Größe der Steuerspannung mehr oder weniger unterdrückt.

Die an der Steuerelektrode jeweils anliegende Gleichspannung wird bei Elektronenstrahl-Schweißmaschinen und ähnlichen Vorrichtungen aus einer amplitudenmodulierten Wechselspannung gewonnen, weil eine Wechselspannung leichter hochtransformiert und verstärkt werden kann. Bei Elektronenstrahl-Schweißmaschinen werden für die Steuerung des Elektronenstrahls Gleichspannungen in der Größenordnung von 1 bis 4 Kilovolt benötigt, die aus einer Gleichspannungsquelle nur schwer zu gewinnen sind.

Die Trägerfrequenz der amplitudenmodulierten Wechselspannungen beträgt oft 20 KHz, während die Modulationsfrequenzen zwischen 0 und 200 Hz liegen. Für die Spannungsversorgung des Wehnelt-Zylinders ist eigentlich nur die Modulationsfrequenz von Interesse, denn die Trägerfrequenz dient lediglich dazu, die Transformatoren und Verstärker möglichst klein auslegen zu können. Man ist deshalb bestrebt, die Trägerfrequenz von der Ansteuerung des Wehnelt-Zylinders ganz zu unterdrücken und nur die Modulationsfrequenz herauszufiltern.

Es ist bereits eine Schaltungsanordnung für einen Wechselrichter bekannt, der eingangsseitig an eine Gleichspannungsquelle und ausgangsseitig über einen Wechselrichtertransformator mit Eisenkern an einen Verbraucher angeschlossen ist (DE—A1—2 615 691). Diese Schaltungsanordnung weist eine an einen Transformator angeschlossene Gleichrichterbrückenschaltung auf, die mit einem Bürdenwiderstand abgeschlossen ist, dem ein Kondensator zur Unterdrückung von Störspannungsspitzen parallelgeschaltet ist. Die Spannung am Bürdenwiderstand bildet dabei den Betrag eines Magnetisierungsstroms ab. Der Transformator, an den die Gleichrichterschaltung angeschlossen ist, arbeitet als Differenzstromwandler, und der Bürdenwiderstand wandelt den eingeprägten Strom, der von der Gleichrichterbrückenschaltung kommt, in eine dem Strom proportionale Spannung um. Eine Demodulations- und Filterwirkung der Kondensator-Bürdenwiderstand-Kombination tritt bei der bekannten Schaltungsanordnung nicht auf. Außerdem ist im Anschluß an die Parallelschaltung von Bürdenwiderstand und Entstörkondensator noch eine Reihenschaltung aus einem weiteren Widerstand und einem Kondensator vorgesehen, wobei der Kondensator unmittelbar mit dem Eingang eines Regelverstärkers verbunden ist.

Weiterhin ist eine Anordnung zur Leistungssteuerung von Hochspannungs-Elektronenstrahlerzeugern bekannt, bei der parallel zu einer Gleichrichterbrücke ein RC-Glied kleiner Zeitkonstante angeordnet ist (DE—A—2 514 805). Bei dieser Anordnung ist auf einem Isoliertransformator eine zusätzliche Wicklung vorgesehen, durch welche die Größe des übertragenen Sollwerts mit einem Istwert in einem Regler verglichen wird. Diese zusätzliche Wicklung bewirkt, daß die Spannung auf der Sekundärseite eines Transformators, der mit einem Gleichrichter verbunden ist, eine Rechteckform aufweist. Hierdurch entsteht eine Gleichspannung aus einer Vielzahl von aneinandergesetzten Rechtecken.

Schließlich ist auch eine Schaltungsanordnung für die Ansteuerung eines Wehnelt-Zylinders bekannt, mit der es möglich ist, die Restwelligkeit der Steuerspannung zu verringern (DE—C—2 928 301). Hierbei ist zwischen einem Gleichrichter, der die amplitudenmodulierte Wechselspannung demoduliert, und der Katoden-Steuerelektroden-Strecke eine Schaltungsanordnung vorgesehen, die eine LC-Kombination aus mindestens zwei in Reihe geschalteten LC-Gliedern in Verbindung mit mindestens zwei parallel zur Strecke Katode-Steuerelektrode bzw. Zweiweggleichrichter gelegten Kondensatoren ist, wobei sich die Resonanzfrequenzen der LC-Glieder etwa wie 2:1 verhalten. Nachteilig ist bei dieser Schaltungsanordnung, daß sie aufgrund der Verwendung von Induktivitäten verhältnismäßig voluminös aufgebaut ist. Die gesamte Filteranordnung hat deshalb einen großen Platzbedarf, der bei modernen Elektronenstrahl-Schweißgeräten und dergleichen unerwünscht ist.

Der Erfindung liegt die Aufgabe zugrunde, bei einer Schaltungsanordnung nach dem Oberbegriff des Patentanspruchs 1 ein Filter zu schaffen, das ohne Induktivitäten auskommt und klein aufgebaut werden kann, obwohl das Spannungssignal, welches auf einen Gleichrichter gegeben wird, sinusförmig ist.

Diese Aufgabe wird gemäß den kennzeichnenden Merkmalen des Patentanspruchs 1 gelöst.

Der mit der Erfindung erzielte Vorteil besteht darin, daß mittels eines besonderen RC-Filters aus einer amplitudenmodulierten Trägerfrequenz von 20 KHz Modulationsfrequenz von 0 bis 200 Hz bei einer Betriebsspannung von 3 KV herausgefiltert werden können, wobei der Träger stark unterdrückt wird. Bei Verwendung eines RC-Filters 2. Grades ist es möglich, die Trägerfrequenz auf <1 ‰ zu unterdrücken. Dadurch, daß parallel zum Gleichrichter ein ohmscher Widerstand geschaltet ist, besteht eine galvanische Verbindung zwischen der Katode und der Steuerelektrode, die eine statische Aufladung der Steuerelektrode verhindert. Die gesamte Filterschaltung ist sehr klein, da keinerlei Drosseln verwendet werden. Damit ist es möglich, diese Filterschaltung in einen Schweißgeräte-Kopf einzubauen.

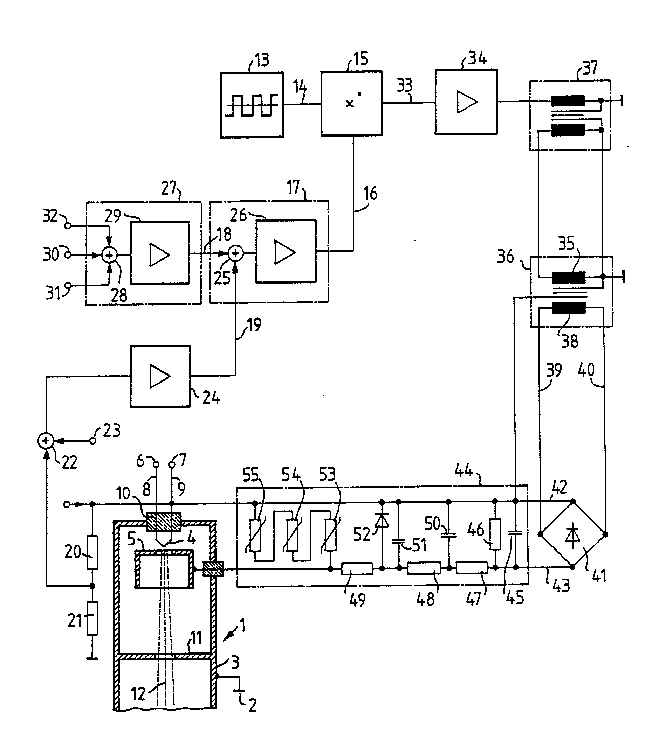

Ein Ausführungsbeispiel der Erfindung ist in der Zeichnung dargestellt und wird im folgenden näher beschrieben.

In der einzigen Figur ist mit 1 ein Hochspannungs-Elektronenstrahlerzeuger bezeichnet, der aus einem an Masse 2 liegenden Gehäuse 3, einer Glühkatode 4 und einem Wehnelt-Zylinder 5 als Steuerelektrode besteht. Die Glühkatode 4 wird über die elektrischen Anschlüsse 6, 7 mit einem Heizstrom versorgt. Die Zuführungsleitungen 8, 9 von den Anschlüssen 6, 7 zur Glühkatode 4 sind mittels eines Durchführungsisolators 10 durch das Gehäuse 1 hindurchgeführt. Eine Beschleunigungsanode 11 ist Teil des Gehäuses 3. Mit der dargestellten und an sich bekannten Anordnung wird bei Anlegung einer entsprechenden Spannung ein Elektronenstrahl 12 erzeugt, der für die einleitend beschriebenen Zwecke verwendet werden kann.

Die Anordnung zur Leistungssteuerung besitzt einen Impulsgenerator 13, der Rechteckimpulse von konstanter Amplitude und konstanter Frequenz, beispielsweise von 20 KHz erzeugt und über eine Leitung 14 einem Multiplizierer 15 zuführt, der über eine Leitung 16 ein Gleichspannungssignal erhält, welches von einer Kompensationseinrichtung 17 geliefert wird. Der Kompensationseinrichtung 17 wird über eine Leitung 18 eine Steuerspannung und über eine Leitung 19 die Regelabweichung der Hochspannung zugeführt. Diese Regelabweichung wird dadurch gebildet, daß eine an einem Spannungsteiler 20, 21 abgegriffene Spannung an einem Additionsglied 22 dem Hochspannungssollwert überlagert wird, der an einen Anschluß 23 ansteht. Die Summe der beiden Spannungen wird sodann einem Verstärker 24 zugeführt, dessen Ausgang mit einem weiteren Additionsglied 25 verbunden ist. Der Spannungsteiler 20, 21, das Additionsglied 22 und der Verstärker 24 können entfallen, wenn die Welligkeit der Hochspannung gering ist. Die Kompensationseinrichtung 17 besteht im wesentlichen aus der Zusammenschaltung des Additionsglieds 25 mit einem Regelverstärker 26, der Proportionalverhalten aufweist. Die Aufgabe dieser Kompensationseinrichtung 17 besteht darin, eine eventuell vorliegende Hochspannungswelligkeit zu erfassen und eine entsprechende Störwertaufschaltung vorzunehmen. Dadurch wird erreicht, daß eine durch die Hochspannung verursachte Welligkeit des Strahlstroms vermindert wird.

Die Steuerspannung wird von einer Regeleinrichtung 27 geliefert, die ähnlich wie die Kompensationseinrichtung 17 aufgebaut ist, d.h. es sind ebenfalls ein Additionsglied 28 und ein Regelverstärker 29 vorgesehen. Dieser Regelverstärker 29 besitzt jedoch PI- oder PID-Verhalten. Der Regeleinrichtung 27 ist über einen Anschluß 30 eine von einem Potentiometer gelieferte Sollwertspannung aufgeschaltet, während der Istwert des Strahlstroms an einen Anschluß 31 gelegt ist. Die Erfassung des Strahlstroms erfolgt in an sich bekannter Weise und ist deshalb in der Figur nicht näher dargestellt. An einen weiteren Anschluß 32 können wahlweise Sollwerte oder Impulse aus externen Funktionsgeneratoren gelegt werden. Durch einen Vergleich der Eingangsgrößen der Regeleinrichtung 27 ergibt sich eine stetig-variable Steuerspannung, welche die spätere Hüllkurve für die Impulsreihe bildet. Im Multiplizierer 15 wird ein amplitudenmoduliertes Steuersignal gebildet, welches über eine Leitung 33 einen Verstärker 34 aufgeschaltet ist. Die Amplitude der an der Leitung 33 liegenden Rechteckspannung ist dabei stets so groß, daß Stromsollwert und Stromistwert des Strahlstroms übereinstimmen. In dem Verstärker 34 wird die erforderliche Leistung erzeugt, die der Primärwicklung 35 eines ersten Trenntransformators 36 über einen zweiten Trenntransformator 37 aufgeschaltet ist. Dieser Trenntransformator 37 hat die Aufgabe, Überspannungsimpulse, die bei Kurzschlüssen im Strahlerzeuger 1 erzeugt werden, vom Verstärker 34 fernzuhalten.

Der Trenntransformator 36 besitzt eine Sekundärwicklung 38, die über Leitungen 39, 40 mit einem Vollweg-Gleichrichter 41 verbunden ist. In diesem Gleichrichter 41 werden die Ausgangsimpulse des Transformators 36 gleichgerichtet, wobei aufgrund der Auslegung des Impulsgenerators 13 eine Reihe von Impulsen entsteht, deren Hüllkurve dem Ausgangssignal der Regeleinrichtung 27 bzw. der Kompensationseinrichtung 17 entspricht. Das Ausgangssignal des Vollweg-Gleichrichters 41 wird über Leitungen 42, 43 einer als Filter wirkenden Schaltungsanordnung 44 zugeführt.

Diese Schaltungsanordnung weist einen parallel zum Ausgang 42, 43 des Gleichrichters 41 geschalteten Kondensator 45 sowie einen hierzu parallel geschalteten Widerstand 46 auf. Dieser Widerstand 46 ist von großer Bedeutung für die vorliegende Erfindung, da er eine gleichstrommäßige Verbindung zwischen der Katode 4 und dem Wehnelt-Zylinder 5 herstellt und als Verbraucherwiderstand die Entladung der Filterkondensatoren 45—50—51 sicherstellt. Zwischen dem Ausgang 43 des Gleichrichters 41 und dem Wehnelt-Zylinder 5 sind mehrere ohmsche Widerstände 47, 48, 49 in Reihe geschaltet. Zwischen dem Verbindungspunkt der Widerstände 47, 48 einerseits und der Ausgangsleitung 42 andererseits liegt ein Kondensator 50, während zwischen dem Verbindungspunkt der Widerstände 48, 49 einerseits und der Ausgangsleitung 42 andererseits ein Kondensator 51 und eine Diode 52 parallel geschaltet sind. Die Katode der Diode 52 liegt hierbei an der Katode des Elektronenstrahlerzeugers 1. Der Widerstand 49 ist unmittelbar an den Wehnelt-Zylinder 5 angeschlossen. Zwischen der Verbindungsleitung, die den Widerstand 49 mit dem Wehnelt-Zylinder 5 verbindet und der Leitung 42 sind drei in Serie geschaltete Varistoren 53, 54, 55 vorgesehen.

Bei der Schaltungsanordnung 44 handelt es sich im wesentlichen um ein RC-Filter 2. Ordnung. Dieses Filter wird von dem Vollweg-Gleichrichter 41 als Generator gespeist und ist an seinem anderen Ende offen. Im Normalfall soll ein Filter den Generatorwiderstand an einen Verbraucher für eine gewünschte Frequenz anpassen und die nicht gewünschten Frequenzen sperren. Außerdem soll es, bedingt durch eine hohe Güte, möglichst keinen Eigenverbrauch haben. Im vorliegenden Fall filtert die Schaltungsanordnung 44 aus einer amplitudenmodulierten Trägerfrequenz von 20 KHz, die an den Leitungen 39, 40 des Trenntransformators 36 ansteht und die durch den Vollweg-Gleichrichter 41 demoduliert und auf unipolare 40 KHz gebracht wird, die Modulationsfrequenz von 0 bis 200 Hz bei einer Betriebsspannung von 3 KV heraus. Der Träger wird hierbei auf <1 o/oo unterdrückt. Die Zahlenwerte für die Widerstände können hierbei folgende sein: Widerstand 49=100 KΩ, Widerstand 48=500 KΩ, Widerstand 47=500 KΩ, Widerstand 46=1 MΩ. Für die Kondensatoren gelten folgende Zahlenwerte: Kondensator 45=200 pF, Kondensator 50=220 pF, Kondensator 51=220 pF.

Bei der Diode 52 handelt es sich um eine Freilaufdiode für die Schutzbeschaltung des Filters bei Hochspannungs-Überschlägen. Der Widerstand 49 ist ein Freilaufdiodenstrombegrenzungswiderstand. Die Varistoren 53, 54, 55 dienen zur Begrenzung einer Überspannung, die aus den verschiedensten Gründen zwischen der Katode 4 und der Steuerelektrode 5 auftreten können.

## Patentansprüche

1. Schaltungsanordnung für die Steuerung eines Elektronenstrahlerzeugers (1) mit einer Katode (4), einer Anode (11), einer Steuerelektrode (5) und einem Gleichrichter (41), der eine amplitudenmodulierte und sinusförmige Spannung gleichrichtet und diese über ein Filter (44) an die Katode (4) und die Steuerelektrode (5) anlegt, wobei zwischen Katode (4) und Steuerelektrode (5) noch eine Parallelschaltung aus einem ersten Widerstand (46) und einem ersten Kondensator (45) sowie wenigstens ein zweiter Widerstand (47) vorgesehen sind, dadurch gekennzeichnet, daß die Parallelschaltung aus erstem Widerstand (46) und erstem Kondensator (45) unmittelbar an die vom Gleichrichter (41) ausgehenden Spannungszuführungsleitungen (42, 43) zur Katode (4) und Steuerelektrode (5) angeschlossen ist, daß der zweite Widerstand (47) zwischen einer ersten Spannungszuführungsleitung (43) und einem Verbindungspunkt zwischen einem dritten Widerstand (48) und einem zweiten Kondensator (50) liegt, wobei dieser zweite Kondensator (50) direkt an eine zweite Spannungszuführungsleitung (42) angeschlossen ist, und daß der dritte Widerstand (48) mit einem Anschluß eines dritten Kondensators (51) verbunden ist, der mit seinem anderen Anschluß an die zweite Spannungszuführungsleitung (42) angeschlossen ist.

2. Schaltungsanordnung nach Anspruch 1, dadurch gekennzeichnet, daß parallel zum dritten Kondensator (51) eine Diode (52) geschaltet ist, wobei die Katode dieser Diode (52) an der zweiten Spannungszuführungsleitung (42) liegt.

3. Schaltungsanordnung nach Anspruch 1 und Anspruch 2, dadurch gekennzeichnet, daß die Anode der Diode (52) mit einem ersten Anschluß eines Widerstands (49) verbunden ist, dessen zweiter Anschluß an der Steuerelektrode (5) liegt.

4. Schaltungsanordnung nach Anspruch 1, dadurch gekennzeichnet, daß parallel zur Katode-Steuerelektrode-Strecke eine Einrichtung (53 bis 55) zur Begrenzung von Überspannungen vorgesehen ist.

5. Schaltungsanordnung nach Anspruch 1, dadurch gekennzeichnet, daß die Einrichtung zur Begrenzung von Überspannungen Varistoren (53, 54, 55) enthält.

6. Schaltungsanordnung nach Anspruch 2, dadurch gekennzeichnet, daß die Katode der Diode (52) mit der Katode (4) des Elektronenstrahlerzeugers (1) verbunden ist.

7. Schaltungsanordnung nach Anspruch 1, dadurch gekennzeichnet, daß die Steuerelektrode (5) ein Wehneltzylinder ist.

## Revendications

1. Circuit de commande pour générateur de rayons électroniques (1) comprenant une cathode (4), une anode (11), une électrode de commande (5) et un redresseur (41) redressant une tension sinusoïdale et à modulation d'amplitude et appliquant celle-ci au moyen d'un filtre (44) à la cathode (4) et à l'électrode de commande (5), dans lequel un montage en parallèle constitué d'une première résistance (46) et d'un premier condensateur (45) ainsi qu'au moins une seconde résistance (47) sont prévus entre la cathode (4) et l'électrode de commande (5), caractérisé en ce que le montage en parallèle constitué d'une première résistance (46) et d'un premier condensateur (45) est directement relié aux lignes d'alimentation de courant partant du redresseur (41) et menant à la cathode (4) et à l'électrode de commande (5), en ce que la deuxième résistance (47) se situe entre une première ligne d'alimentation de courant (43) et un point de liaison situé entre une troisième résistance (48) et un deuxième condensateur (50), ce deuxième condensateur (50) étant directement relié à une deuxième ligne d'alimentation de courant (42), et en ce que la troisième résistance (48) est reliée à une connexion d'un troisième condensateur (51), lui-même relié au moyen de son autre connexion à la ligne d'alimentation de courant (42).

2. Circuit de commande selon la revendication 1, caractérisé en ce qu'une diode (52) est connectée en parallèle par rapport au troisième condensateur (51), la cathode de cette diode (52) se trouvant à proximité de la deuxième ligne d'alimentation de courant (42).

3. Circuit de commande selon les revendications 1 et 2, caractérisé en ce que l'anode de la diode (52) est reliée à une connexion d'une résistance (49), la deuxième connexion de cette dernière étant branchée sur l'électrode de commande (5).

4. Circuit de commande selon la revendication 1, caractérisé en ce qu'il est prévu un dispositif (53, 55) permettant d'éviter les surtensions, parallèlement à la ligne formée par la cathode et l'électrode de commande.

5. Circuit de commande selon la revendication 1, caractérisé en ce que le dispositif permettant d'éviter des surtensions comprend des varistors (53, 54, 55).

6. Circuit de commande selon la revendication 2, caractérisé en ce que la cathode de la diode (52) est reliée à la cathode (4) du générateur de rayons électroniques (1).

7. Circuit de commande selon la revendication 1, caractérisé en ce que l'électrode de commande (5) est une électrode de modulation de Wehnelt.

**Claims**

1. A circuit arrangement for the control of an electron-beam generator (1) having a cathode (4), an anode (11), a control electrode (5) and a rectifier (41) which rectifies an amplitude-modulated and sinusoidal voltage and applies this, via a filter (44) to the cathode (4) and the control electrode (5), wherein a parallel connection of a first resistor (46) and a first capacitor (45) as well as at least one second resistor (47) are also provided between cathode (4) and control electrode (5), characterised in that the parallel connection of a first resistor (46) and first capacitor (45) is connected directly to the voltage supply lines (42, 43) coming from the rectifier (41) to the cathode (4) and control electrode (5), that the second resistor (47) lies between a first voltage supply line (43) and a junction point between a third resistor (48) and a second capacitor (50), this second capacitor (50) being connected directly to a second voltage supply line (42), and that the third resistor (48) is connected to one terminal of a third capacitor (51) which is connected, by its other terminal, to the second voltage supply line (42).

2. A circuit arrangement according to Claim 1, characterised in that a diode (52) is connected in parallel with the third capacitor (51), the cathode of this diode (52) being connected to the second voltage supply line (42).

3. A circuit arrangement according to Claim 1 and Claim 2, characterised in that the anode of the diode (52) is connected to a first terminal of a resistor (49), the second terminal of which is connected to the control electrode (5).

4. A circuit arrangement according to Claim 1, characterised in that a device (53 to 55) for limiting overvoltages is provided in parallel with the cathode-control-electrode path.

5. A circuit arrangement according to Claim 1, characterised in that the device for limiting overvoltages contains varistors (53, 54, 55).

6. A circuit arrangement according to Claim 2, characterised in that the cathode of the diode (52) is connected to the cathode (4) of the electron-beam generator (1).

7. A circuit arrangement according to Claim 1, characterised in that the control electrode (5) is a modulator electrode.